# EUROPEAN PATENT SPECIFICATION

(11) **EP 2 978 298 B1**
(45) Date of publication and mention of the grant of the patent: **24.04.2019**
(21) Application number: 13879143.9
(22) Date of filing: 22.03.2013
(51) Int. Cl.: H05K 13/08, H05K 13/04

(54) **COMPONENT MOUNTING DEVICE**
KOMPONENTENMONTAGEMASCHINE
MACHINE DE MONTAGE DE COMPOSANTS

(43) Date of publication of application: 27.01.2016
(73) Proprietor: FUJI Corporation, Chiryu Aichi (JP)
(72) Inventor: NISHIYAMA, Satoru, Chiryu, Aichi (JP)
(74) Representative: Grünecker Patent- und Rechtsanwälte PartG mbB
(86) International application number: PCT/JP2013/058248
(87) International publication number: WO 2014/147806

(56) References cited:
- JP-A- 2001 352 196
- JP-A- 2004 172 465
- JP-A- 2005 072 046
- JP-A- 2007 214 212
- JP-A- 2009 130 014
- JP-A- 2012 212 947

## Description

### Technical Field

The present invention relates to a method using a component mounting device which holds a plurality of suction nozzles that sucks a component so as to be replaceable at a predetermined gap on a rotary head in the circumferential direction thereof.

### Background Art

In this kind of rotary head type of component mounting device, during component suction, the rotary head is moved above a feeder, the rotary head is rotated one pitch at a time (arrangement pitch of the suction nozzles), and the component is sucked to all of the suction nozzles of the rotary head by lowering the suction nozzle at a predetermined position of the rotary head, and repeatedly operating so as to suck and raise the component, then the rotary head is moved above a circuit board, the rotary head is rotated one pitch at a time, and the sucked components of all of the suction nozzles of the rotary head are mounted on the circuit board by lowering the suction nozzle at a predetermined position of the rotary head, and repeatedly operating so as to mount the sucked components of the suction nozzles on the circuit board and raise the suction nozzles, and thereafter, generating a component mounting board by alternately repeating a component suction operation and a component mounting operation of the plurality of suction nozzles which are described above.

In such a component mounting device, in order to monitor the normal performance of mounting of the components by each suction nozzle, as described in PTL 1 (JP-A-2008-311476), a side surface image of two suction nozzles, which are positioned on both sides (one pitch front and one pitch back) of the suction nozzle that is raised to carry out the component mounting operation, is captured using an imaging device, the image is processed and whether or not each suction nozzle sucks a component and the suction posture of the component are recognized, and as a result of image recognition, an suction error or abnormal suction of the component is detected, and a component mounting error (taking back of the component) is detected. Further component mounting devices are known from PTL 2, PTL 3, and PTL 4. In addition, the component mounting device is provided with a nozzle station which stores the suction nozzle for replacement, and when replacing the suction nozzle, since the rotary head is moved above the nozzle station, the suction nozzle which is held by the rotary head is automatically replaced, and whether or not the nozzle replacement operation is normally performed is confirmed, the presence or absence of the suction nozzle at the nozzle replacement position (the same position as the position at which the suction nozzle is raised during component suction and mounting) of the rotary head is detected by a light sensor.

### Citation List

### Patent Literature

PTL 1: JP-A-2008-311476
PTL 2: JP 2004 172465 A
PTL 3: JP 2009 130014 A
PTL 4: JP 2007 214212 A

### Summary of Invention

### Technical Problem

In a case where the imaging device which captures a side surface image of the two suction nozzles and the light sensor for confirming nozzle replacement which are described above are mounted on the component mounting device, it is necessary to dispose at least both of an optical system unit and a light sensor for nozzle replacement confirmation of the imaging device on the side of the suction nozzles, but in this configuration, there is a possibility that the light sensor for nozzle replacement confirmation interferes with a component already mounted on the circuit board. For this reason, in a case where the component already mounted on the circuit board is a large component, a mechanism will be necessary which causes the light sensor for nozzle replacement confirmation to move so as to retreat, and the cost increases,

Therefore, an object which the present invention achieves is having a function in which both of a component suction and mounting operation and a nozzle replacement operation are confirmed at relatively low cost.

### Solution to Problem

In order to solve the above problem, there is provided a component mounting method as in claim 1, according to which a component mounting device holds a plurality of suction nozzles, which sucks a component, so as to be replaceable at a predetermined gap on a rotary head in the circumferential direction thereof, including: an imaging device which collectively captures a side surface image of at least a portion of the suction nozzle which is raised in order to carry out a component suction and mounting operation or a nozzle replacement operation out of the plurality of suction nozzles that are held by a rotating head, and a side surface image of at least the lower end section of the two suction nozzles which are positioned at both sides of the suction nozzle; and an image
processing device which processes the image which is captured by the imaging device, in which the imaging device has one image sensor and an optical system unit that forms a side surface image of an imaging target part of each of the three suction nozzles on a light-receiving surface of the image sensor such that the side surface images do not overlap, and the image processing device processes images of the two suction nozzles, which are positioned on both ends of the row of the three suction nozzles, that are captured as imaging targets during the component suction and mounting operation so as to confirm whether or not the suction nozzles suck a component and the suction posture of the components, and the image of the suction nozzle, which is positioned at the middle of the three suction nozzles that is captured during nozzle replacement operation, is processed as the imaging target to recognize the presence or absence of the suction nozzle.

In this configuration, since it is possible to confirm both of the component suction and mounting operation and the nozzle replacement operation using the side surface image of the imaging target part of each of three suction nozzles which are collectively captured by the imaging device, it is not necessary to mount a light sensor for recognizing nozzle replacement, and it is possible to mount a component with a function in which both of the component suction and mounting operation and the nozzle replacement operation are confirmed at a relatively low cost.

In this case, the optical system unit may be configured such that a side surface image of an upper section of the suction nozzle which is positioned in the middle of the three suction nozzles is formed on an upper section side on the light-receiving surface of the image sensor, and the side surface images of an upper section of the two suction nozzles which are positioned on both ends of the row of the three suction nozzles are formed in a line left to right at the lower end side on the light-receiving surface of the image sensor.

Alternatively, the optical system unit may be configured such that the side surface image of the imaging target part of the three suction nozzles is formed so as to line up on the light-receiving surface of the image sensor in the transverse direction.

### Brief Description of Drawings

Fig. 1 is a perspective view illustrating a configuration of the main sections of embodiment 1 of the present invention.
Fig. 2 is a perspective view illustrating a configuration (a state in which an upper surface cover is removed) of an optical system unit of embodiment 1 of the present invention,
Fig. 3 is a perspective view illustrating a configuration of an imaging device of embodiment 1 of the present invention.
Fig. 4 is a view illustrating an image which is captured by the imaging device of embodiment 1 of the present invention.
Fig. 5 is a perspective view illustrating a configuration of an optical system unit of an imaging device of embodiment 2 of the present invention.
Fig. 6 is a view illustrating an image which is captured by the imaging device of embodiment 2 of the present invention.

### Description of Embodiments

Embodiments 1 and 2 which specify embodiments of the present invention will be described below.

### Embodiment 1

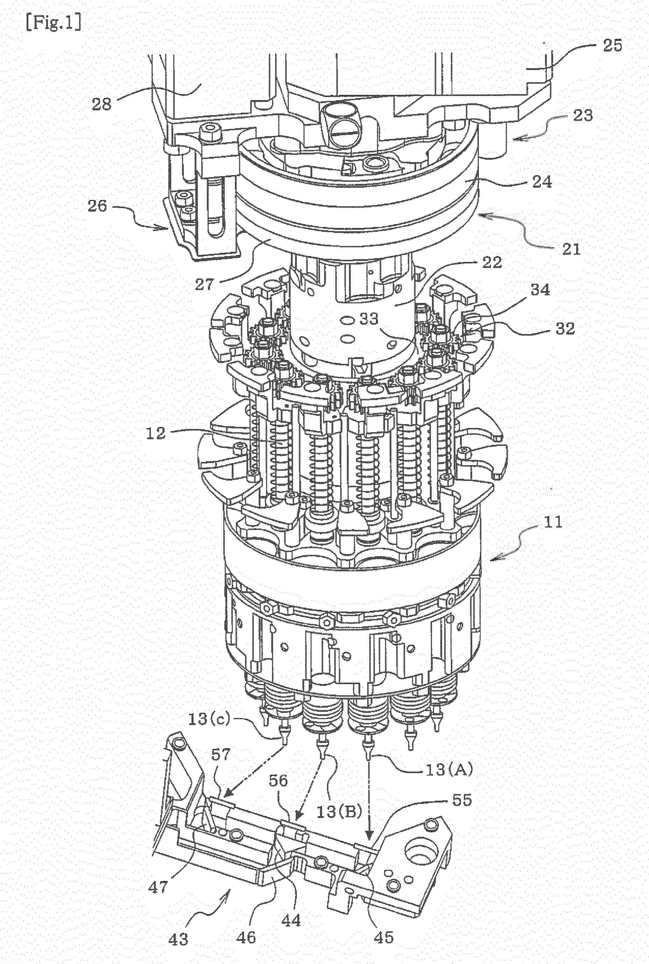

Embodiment 1 of the present invention will be described based on Fig. 1 to Fig. 4. First, the configuration of a rotary head 11 of a component mounting device will be described based on Fig. 1.

A plurality of nozzle holders 12 is held at a predetermined gap in the rotary head 11 so as to be able to be lowered in the circumferential direction thereof, a suction nozzle 13 which sucks a component is engaged and held with a downward orientation so as to be able to be replaced (so as to be attachable and detachable) on the lower end of each nozzle holder 12.

The rotary head 11 is engaged and held so as to be able to be replaced (so as to be attachable and detachable) on an R-axis 22 which extends below a head holding unit 21 that is moved by a head moving device (not shown in the drawings) . Here, Fig. 1 illustrates a state in which the rotary head 11 is moved so as to be removed downward from the R-axis 22. An R-axis driving mechanism 23 (a head rotation mechanism), which rotates the R-axis 22, is attached to the head holding unit 21. The plurality of nozzle holders 12 revolve integrally with the plurality of suction nozzles 13 in the circumferential direction of the rotary head 11 due to the R-axis driving mechanism 23 rotating an R-axis gear 24 (teeth surface not shown in the drawings) which is fixed to the upper end of the R-axis 22 using an R-axis motor 25, and rotating the rotary head 11 by setting the R-axis 22 as the center.

A Q-axis gear 27 (teeth surface not shown in the drawings) which is a driving source of a Q-axis driving mechanism 26 (nozzle rotation mechanism) is inserted into the R-axis 22 so as to be rotatable, and the Q-axis gear 27 rotates around the R-axis 22 due to a Q-axis motor 28.

In addition, a nozzle rotation gear mechanism 32 in which rotational force of the Q-axis gear 27 reaches each nozzle holder 12 is provided in the rotary head 11. Each nozzle holder 12 rotates about an axial center line of each of the respective nozzle holders 12, and the orientation (angle) of each component, which is sucked to each of the suction nozzles 13 that are held by each of the nozzle holders 12, is corrected by the nozzle rotation gear mechanism 32 meshing a cylindrical gear 33 (teeth surface not shown in the drawings), which is supported so as to be rotatable concentrically on the upper section side of the rotary head 11, and a small gear 34 which is attached to each nozzle holder 12, rotating the cylindrical gear 33 and rotating the small gear 34 of each nozzle holder 12 using the Q-axis gear 27 of the head holding unit 21. The inner diameter of the cylindrical gear 33 is formed so as to be slightly larger than the outer diameter of the R-axis 22 such that it is possible to insert the R-axis 22 of the head holding unit 21 inside the cylindrical gear 33.

In addition to the R-axis driving mechanism 23 and the Q-axis driving mechanism 26, a Z-axis driving mechanism (not shown in the drawings) which has a Z-axis motor (not shown in the drawings) as a driving source is provided so as to move integrally with the head holding unit 21, during the component suction and mounting operation and the nozzle replacement operation, the nozzle holder 12 is lowered at a predetermined stopping position of a revolving trajectory of the nozzle holder 12 using the Z-axis driving mechanism, the component is sucked to the suction nozzle 13, the component is mounted on a circuit board (not shown in the drawings), and the suction nozzle 13 which is held in the nozzle holder 12 is replaced. Here, a nozzle station (not shown in the drawings) which stores the suction nozzle 13 for replacement is provided in the component mounting device.

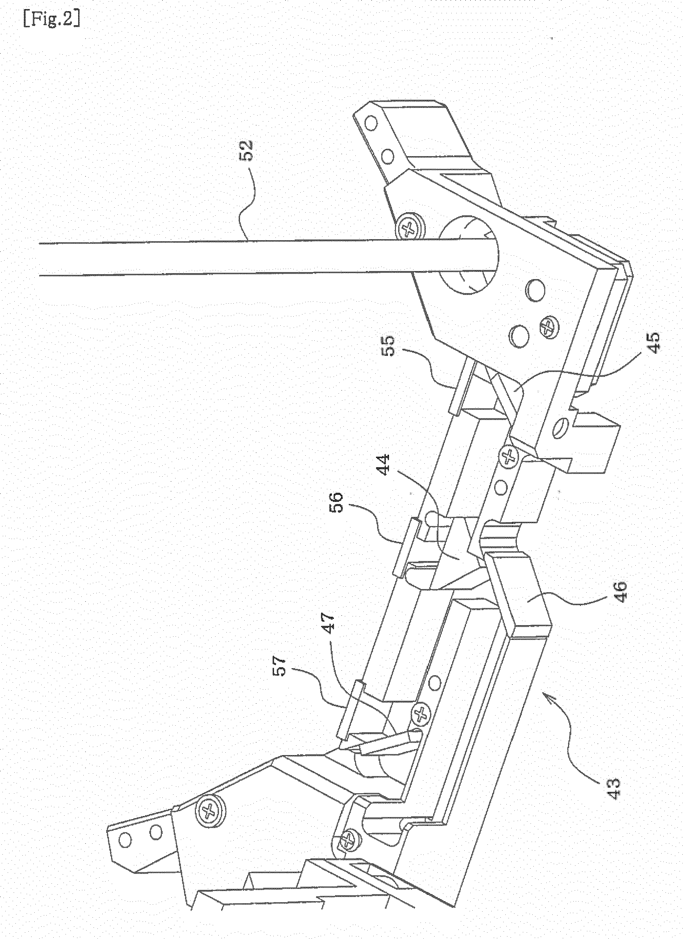

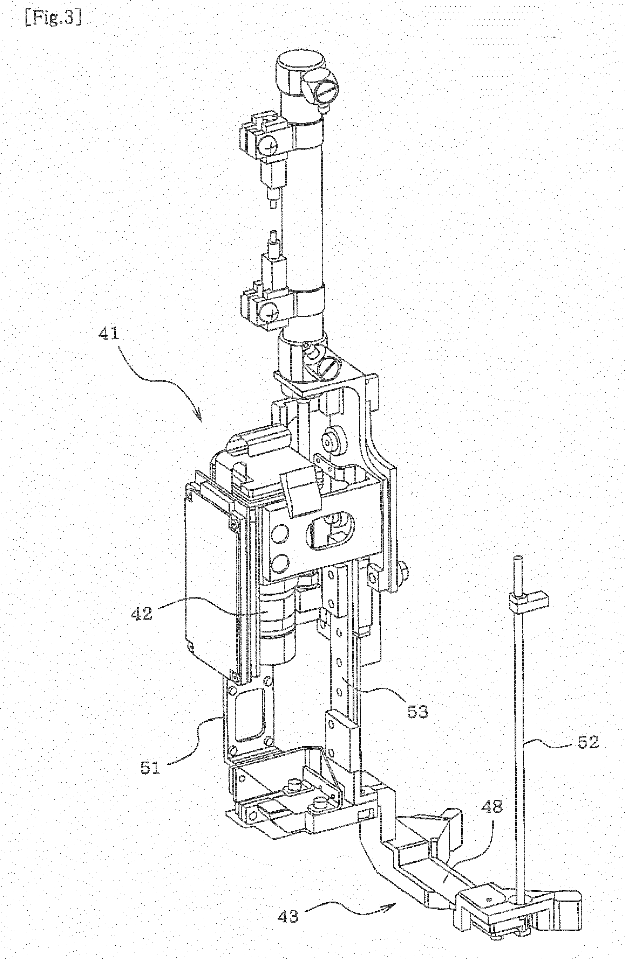

The head holding unit 21 is configured such that the imaging device 41 (refer to Fig. 3) is attached which images a component that is sucked to the suction nozzle 13 from the side, and the imaging device 41 moves integrally with the rotary head 11. As shown in Fig. 3, the imaging device 41 is provided with one image sensor 42 (camera) and an optical system unit 43, and as shown in Fig. 2, a prism 44, mirrors 45 to 47, an illumination light source, and the like are disposed inside the optical system unit 43, and an upper surface cover 48 (refer to Fig. 3) is mounted on the upper surface of the optical system unit 43.

As shown in Fig. 1, the optical system unit 43 is configured such that, out of the plurality of suction nozzles 13 that are held by a rotary head 11, a side surface image of at least a portion of the suction nozzle 13 (B) which is raised in order to carry out the component suction and mounting operation or the nozzle replacement operation, and a side surface image of at least the lower end section of the two suction nozzles 13 (A and C) which are positioned at both sides of the suction nozzle 13(B) are collectively captured. The optical system unit 43 is disposed on the side of the three suction nozzles 13(A, B, and C) which is the imaging target, and as shown in Fig. 3, the base end side and the distal end side of the optical system unit 43 are attached to a support frame 51 and a support shaft 52. The image sensor 42 is fixed to the head holding unit 21 side via a main body frame 53 of the imaging device 41 in a state in which the light-receiving surface side is orientated downward.

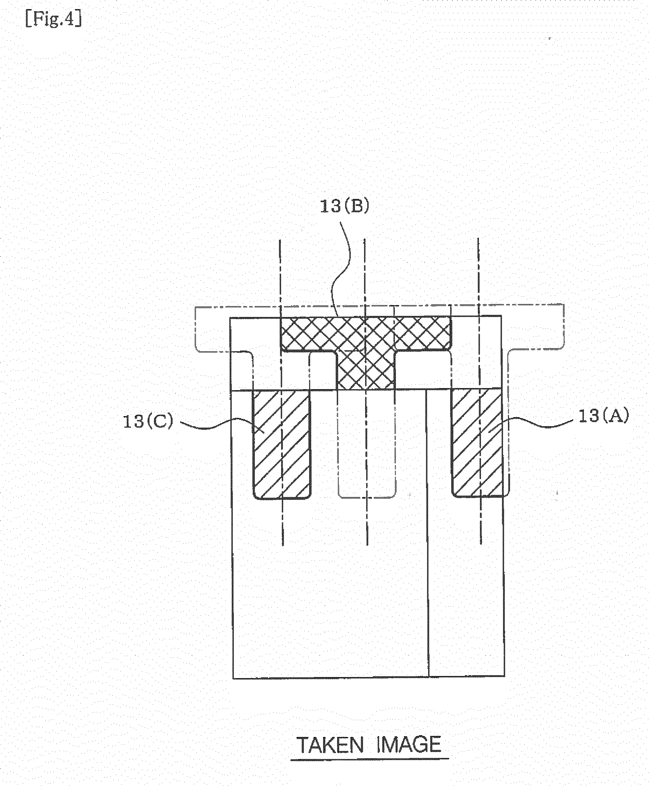

The optical system unit 43 is configured such that the side surface image of the imaging target part of the three suction nozzles 13(A, B, and C) is formed so as not to overlap with each side surface image on the light-receiving surface of the image sensor 42. As shown in Fig. 4, in embodiment 1, the optical system unit 43 is configured such that a side surface image of an upper section of the suction nozzle 13 (B) which is positioned in the middle of the three suction nozzles 13(A, B, and C) which are the imaging target is formed at an upper section side on the light-receiving surface of the image sensor 42, and the side surface images of a lower section of the two suction nozzles 13(A and C) which are positioned on both ends of the row of the three suction nozzles 13(A, B, and C) are formed in a line left to right at the lower end side of the light-receiving surface of the image sensor 42. In detail, the height of the prism 44 which is positioned in a center section of the optical system unit 43 is lower than the height of the mirror 46 which is positioned in the rear, and the side surface image of the upper section of the center suction nozzle 13(B) is reflected on the upper section side of the mirror 46 at the rear through a space at the upper side of the prism 44 to be formed at the upper section side of the light-receiving surface of the image sensor 42. Then, a side surface image in a lower section of the two suction nozzles 13(A and C) which are positioned on both ends of the row of the three suction nozzles 13(A, B, and C) which are the imaging target is reflected on the prism 44 side by the mirrors 45 and 47 which are positioned on both sides of the optical system unit 43, is further refracted to the mirror 46 side which is positioned at the rear by the prism 44, and is formed at the lower section side of the light-receiving surface of the image sensor 42 by reflecting using the mirror 46. In this case, the height of the mirrors 45 and 47 which are positioned at both sides of the optical system unit 43 is the same as the height of the prism 44. Here, transparent covers 55 to 57 are respectively mounted at the light-receiving side (imaging target side) of the mirrors 45 and 47 and the prism 44.

During operation of the component mounting device, during component suction, the rotary head 11 is moved above a feeder (not shown in the drawings), the rotary head 11 is rotated one pitch at a time (arrangement pitch of the suction nozzles 13), and a component is sucked to all of the suction nozzles 13 of the rotary head 11 by lowering the suction nozzles 13 at a predetermined position on the rotary head 11, and repeatedly operating so as to suck and raise the component, then the rotary head 11 is moved above a circuit board, the rotary head 11 is rotated one pitch at a time, and the sucked components of all of the suction nozzles 13 of the rotary head 11 are mounted on the circuit board by lowering the suction nozzles 13 at a predetermined position of the rotary head 11, and repeatedly operating so as to mount the sucked components of the suction nozzles 13 on the circuit board and raise the suction nozzles 13, and thereafter, generating a component mounting board by alternately repeating a component suction operation and a component mounting operation of the plurality of suction nozzles 13 which are described above.

In addition, in a case where the suction nozzle 13 which is held on the rotary head 11 is replaced, the suction nozzle 13 which is held on the rotary head 11 is automatically replaced by moving the rotary head 11 above the nozzle station (not shown in the drawings).

The control device (not shown in the drawings) which controls the component suction and mounting operation and the nozzle replacement operation of the component mounting device also functions as an image processing device which processes images that are captured by the imaging device 41, and during the component suction and mounting operation, the images of the two suction nozzles 13(A and C) which are positioned on both ends of the row of the three suction nozzles 13(A, B, and C) that are captured, are processed as an imaging target to recognize whether or not the suction nozzles 13 (A and C) suck a component and the suction posture of the component are recognized.

For example, since during the component mounting operation, the component being sucked to the suction nozzle 13 (A) of one pitch before (the mounting position directly before) the lowered suction nozzle 13 (B) is in a normal state, as a result of image recognition, it is recognized from the image whether or not the component is sucked to the subsequent suction nozzle 13 due to the rotary head 11 being rotated by one pitch without performing the component mounting operation for the suction nozzle 13 (A) if it is determined that the component is not sucked to the suction nozzle 13 (A) or an abnormal orientation is determined. In addition, during the component mounting operation, since the component not being sucked to the suction nozzle 13 (C) one pitch after (the mounting position directly after) the lowered suction nozzle 13(B) is in the normal state, as a result of image recognition, the component mounting operation is performed again by determining a mounting error (taking back of the component) if it is determined that the component is sucked to the suction nozzle 13(C).

In addition, also during the component mounting operation, the images that are captured of the two suction nozzles 13(A and C) which are positioned on both ends of the row of the three suction nozzles 13(A, B, and C) are processed as imaging targets so as to confirm whether or not the suction nozzles 13(A and C) suck a component and the suction posture of the components. During the component mounting operation, since the component being sucked to the suction nozzle 13(C) one pitch after (the suction position directly after) the lowered suction nozzle 13(B) is in the normal state, as a result of image recognition, the component suction operation is performed again by determining a component suction error if it is determined that the component is not sucked to the suction nozzle 13(C). In addition, during the component mounting operation, the component suction operation of the suction nozzle 13(B) of the current time is determined to be the final component suction operation if it is determined that the component is sucked to the suction nozzle 13(A) of one pitch before (the suction position directly before) the lowered suction nozzle 13(B).

Meanwhile, during a nozzle replacement operation, the image that is captured of the suction nozzle 13(B) which is positioned in the middle of the three suction nozzles 13(A, B, and C) is processed as an imaging target so as to confirm the presence or absence of the suction nozzle 13(B). For example, in a case where the suction nozzle 13(B) is removed from the rotary head 11, it is determined that removal of the suction nozzle 13(B) is performed normally if it is determined that the nozzle is present prior to the operation start up, and it is determined that the nozzle is absent after removal. In addition, in a case where the suction nozzle 13 for replacement which is placed on the nozzle station in the nozzle holder of the rotary head 11 is attached, it is determined that the attachment of the suction nozzle 13 is performed normally if it is determined that the nozzle is absent prior to attachment operation start up, and it is determined that the nozzle is present after the attachment operation.

In the present embodiment 1 described above, the imaging device 41 is provided which collectively captures a side surface image of at least a portion of the raised suction nozzle 13(B), and a side surface image of at least the lower end section of the two suction nozzles 13(A and C) which are positioned at both sides in order to carry out the component suction and mounting operation and the nozzle replacement operation out of the plurality of suction nozzles 13 that are held by the rotary head 11. The imaging device 41 has one image sensor 42 and an optical system unit 43 that forms a side surface image of an imaging target part of each of the three suction nozzles 13 (A, B, C) on a light-receiving surface of the image sensor 42 such that the side surface images do not overlap. The images that are captured of the two suction nozzles 13(A, C) which are positioned on both ends of the row of the three suction nozzles 13(A, B, C) are processed as imaging targets during the component suction and mounting operation so as to confirm whether or not the suction nozzles 13(A, C) suck a component and the suction posture of the components. Since the image of the suction nozzle 13 which is positioned at the middle of the three suction nozzles 13 (A, B, C), which is captured during the nozzle replacement operation, is processed as an imaging target to recognize the presence or absence of the suction nozzle 13, it is possible to confirm both of the component suction and mounting operation and the nozzle replacement operation using the image which is captured by the imaging device 41, it is not necessary to mount a light sensor for recognizing nozzle replacement, and it is possible to mount a component with a function in which both of the component suction and mounting operation and a nozzle replacement operation are confirmed at a relatively low cost.

### Embodiment 2

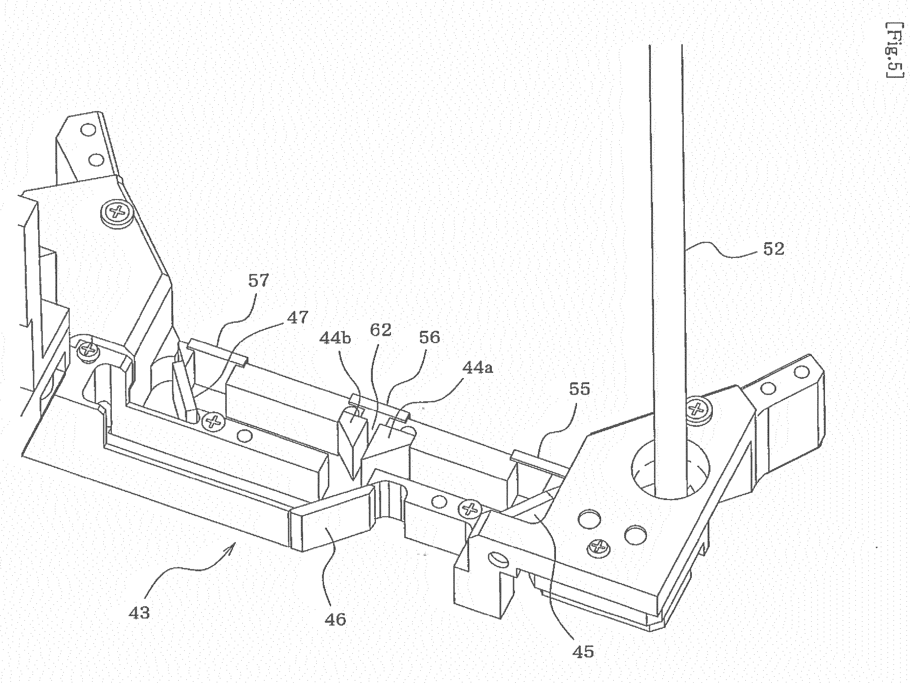

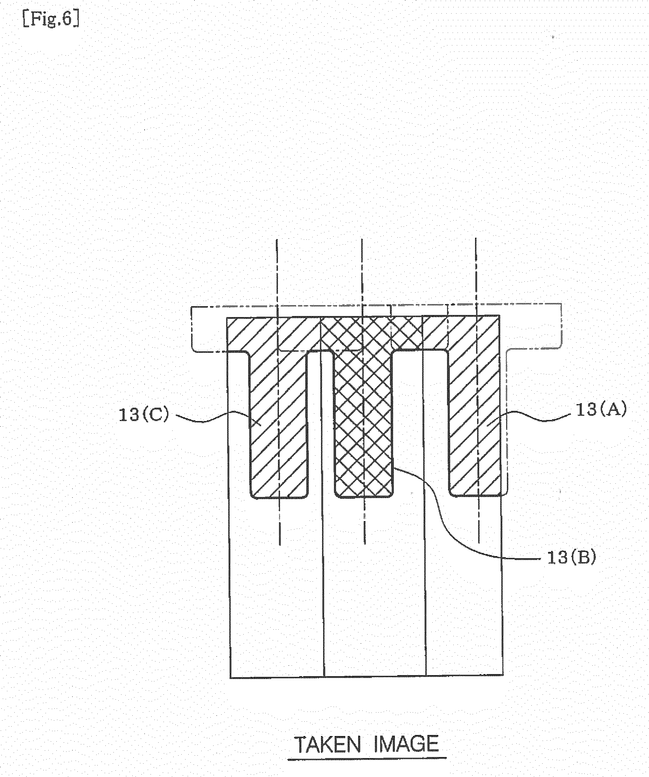

Next, embodiment 2 of the present invention will be described using Fig. 5 and Fig. 6. However, the same reference numerals are given for portions which are practically the same as embodiment 1, description is omitted or simplified, and main different portions are described.

In the present embodiment 2, two split prisms 44a and 44b are disposed at the center of the optical system unit 43, a longitudinal slit 62 which passes through in the front and back direction is formed between the two prisms 44a and 44b, and a side surface image of at least a portion of the suction nozzle 13(B) that is positioned in the middle of the three suction nozzles 13(A, B, and C) which are the imaging target is passed through by the longitudinal slit 62 between the prisms 44a and 44b, is reflected by the mirror 46 that is positioned at the rear of the prisms 44a and 44b, and is formed at the center of the light-receiving surface of the image sensor 42. Then, a side surface image in a lower section of the two suction nozzles 13(A and C) which are positioned on both ends out of the three suction nozzles 13(A, B, and C) which are the imaging target is reflected on the prisms 44a and 44b side by the mirrors 45 and 47 which are positioned on both sides of the optical system unit 43, is further refracted to the mirror 46 side which is positioned at the rear by each of the prisms 44a and 44b, and is formed at both side sections of the light-receiving surface of the image sensor 42 by reflecting using the mirror 46. Thereby, as shown in Fig. 6, the side surface image of the imaging target part of the three suction nozzles 13(A, B, and C) is formed so as to line up on the light-receiving surface of the image sensor 42 in the transverse direction. In this case, the heights of the prisms 44a and 44b are the same as the heights of the mirrors 45 to 47. Other configurations are the same as in embodiment 1.

Even in embodiment 2 described above, it is possible to achieve the same effects as embodiment 1. Here, the present invention is not limited to embodiments 1 and 2, and the configuration of the rotary head 11 and the configuration of the optical system unit 43 may be appropriately modified, and needless to say implementation is possible by making various modifications within a range which does not deviate from the gist of the present invention.

### Reference Signs List

11 ... ROTARY HEAD, 12 ... NOZZLE HOLDER, 13 ... SUCTION NOZZLE, 21 ... HEAD HOLDING UNIT, 41 ... IMAGING DEVICE, 42 ... IMAGE SENSOR, 43 ... OPTICAL SYSTEM UNIT, 44, 44a, 44b ... PRISM, 45 to 47 ... MIRROR, 55 to 57 ... TRANSPARENT COVER

## Claims

1. Component mounting method using a component mounting device that is configured to hold a plurality of suction nozzles (13), which are configured to suck a component, so as to be replaceable at a predetermined gap on a rotary head (11) in the circumferential direction thereof, the component mounting device comprising:
an imaging device (41) which is configured to collectively capture a side surface image of at least a portion of the suction nozzle (13B) which is raised in order to carry out a component suction and mounting operation or a nozzle replacement operation out of the plurality of suction nozzles (13) that are held by the rotary head (11), and a side surface image of at least the lower end section of the two suction nozzles (13A, 13C) which are positioned at both sides of the suction nozzle (13B); and
an image processing device which is configured to process the image which is captured by the imaging device (41),
wherein the imaging device (41) has one image sensor (42) and an optical system unit (43) that is configured to form a side surface image of an imaging target part of each of the three suction nozzles (13A, 13B, 13C) on a light-receiving surface of the image sensor (42) such that the side surface images do not overlap,
the component mounting method being **characterized by**
causing the image processing device to process images of the two suction nozzles (13A, 13C), which are positioned on both ends of the row of the three suction nozzles (13A, 13B, 13C), that are captured as imaging targets during the component suction and mounting operation so as to confirm whether or not the suction nozzles (13A, 13C) suck a component and the suction posture of the components, and to process the image of the suction nozzle (13B), which is positioned at the middle of the three suction nozzles (13A, 13B, 13C) that is captured during nozzle replacement operation, as the imaging target to recognize the presence or absence of the suction nozzle (13B).

2. The component mounting method according to claim 1,
wherein the optical system unit (43) is configured such that a side surface image of an upper section of the suction nozzle (13B) which is positioned in the middle of the three suction nozzles (13A, 13B, 13C) is formed on an upper section side on the light-receiving surface of the image sensor (42), and the side surface images of an upper section of the two suction nozzles (13A, 13C) which are positioned on both ends of the row of the three suction nozzles (13A, 13B, 13C) are formed in a line left to right at the lower end side on the light-receiving surface of the image sensor (42).

3. The component mounting method according to claim 1,
wherein the optical system unit (43) is configured such that the side surface image of the imaging target part of the three suction nozzles (13A, 13B, 13C) is formed so as to line up on the light-receiving surface of the image sensor (42) in the transverse direction.

## Patentansprüche

1. Verfahren zum Montieren von Bauteilen unter Verwendung einer Vorrichtung zum Montieren von Bauteilen, die so eingerichtet ist, dass eine Vielzahl von Saugdüsen (13), die so eingerichtet sind, dass sie ein Bauteil ansaugen, so, dass sie ausgetauscht werden können, mit einem vorgegebenen Zwischenraum an einem Dreh-Kopf (11) in dessen Umfangsrichtung gehalten werden, wobei die Vorrichtung zum Montieren von Bauteilen umfasst:
eine Bilderzeugungsvorrichtung (41), die so eingerichtet ist, dass sie ein Bild einer Seitenfläche wenigstens eines Abschnitts der Saugdüse (13B), die angehoben wird, um einen Vorgang zum Ansaugen und Montieren eines Bauteils oder einen Vorgang zum Austauschen einer Düse der Vielzahl von Saugdüsen (13), die von dem Dreh-Kopf (11) gehalten werden, und ein Bild einer Seitenfläche wenigstens des unteren End-Teilabschnitts der zwei Saugdüsen (13A, 13C), die an beiden Seiten der Saugdüse (13B) positioniert sind, zusammen aufnimmt; sowie
eine Bildverarbeitungsvorrichtung, die so eingerichtet ist, dass sie das Bild verarbeitet, das durch die Bilderzeugungsvorrichtung (41) aufgenommen wird,
wobei die Bilderzeugungsvorrichtung (41) einen Bild-Sensor (42) und eine Optiksystem-Einheit (43) aufweist, die so ausgebildet ist, dass sie ein Bild einer Seitenfläche eines Bilderzeugungsobjekt-Teils jeder der drei Saugdüsen (13A, 13B, 13C) auf einer Lichtempfangs-Fläche des Bild-Sensors (42) so erzeugt, das sich die Bilder der Seitenflächen nicht überlappen,
wobei das Verfahren zum Montieren von Bauteilen **dadurch gekennzeichnet ist, dass**
die Bildverarbeitungsvorrichtung veranlasst wird, Bilder der an beiden Enden der Reihe der drei Saugdüsen (13A, 13B, 13C) positionierten zwei Saugdüsen (13A, 13C) zu verarbeiten, die als Bilderzeugungsobjekte während des Vorgangs des Ansaugens und Montierens von Bauteilen aufgenommen werden, um die Tatsache, ob die Saugdüsen (13A, 13C) ein Bauteil ansaugen, und die Ansaug-Lage der Bauteile zu prüfen, und das Bild der in der Mitte der drei Saugdüsen (13A, 13B, 13C) positionierten Saugdüse (13B) zu verarbeiten, das während des Vorgangs zum Austauschen der Düse als das Bilderzeugungsobjekt aufgenommen wird, um das Vorhandensein oder Nichtvorhandensein der Saugdüse (13B) zu erkennen.

2. Verfahren zum Montieren von Bauteilen nach Anspruch 1,
wobei die Optiksystem-Einheit (43) so eingerichtet ist, dass ein Bild der Seitenfläche eines oberen Teilabschnitts der in der Mitte der drei Saugdüsen (13A, 13B, 13C) positionierten Saugdüse (13B) an einem oberen Teilabschnitt der Lichtempfangs-Fläche des Bild-Sensors (42) erzeugt wird, und die Bilder der Seitenfläche eines oberen Teilabschnitts der an beiden Enden der Reihe der drei Saugdüsen (13A, 13B, 13C) positionierten zwei Saugdüsen (13A, 13C) auf einer von links nach rechts verlaufenden Linie an der Seite des unteren Endes der Lichtempfangs-Fläche des Bild-Sensors (42) erzeugt werden.

3. Verfahren zum Montieren von Bauteilen nach Anspruch 1,
wobei die Optiksystem-Einheit (43) so eingerichtet ist, dass das Bild der Seitenfläche des Bilderzeugungsobjekt-Teils der drei Saugdüsen (13A, 13B, 13C) so erzeugt wird, dass sie auf der Lichtempfangs-Fläche des Bild-Sensors (42) in der Querrichtung aufgereiht sind.

## Revendications

1. Procédé de montage de composants utilisant un dispositif de montage de composants qui est configuré pour maintenir une pluralité de buses aspirantes (13), qui sont configurées pour aspirer un composant, de sorte à être remplaçable selon un écart prédéterminé sur une tête rotative (11) dans la direction circonférentielle de celle-ci, le dispositif de montage de composants comprenant :
un dispositif d'imagerie (41) qui est configuré pour capturer collectivement une image de surface latérale d'au moins une partie de la buse aspirante (13B) qui est levée pour effectuer une opération d'aspiration et de montage de composant ou une opération de remplacement de buse parmi la pluralité de buses aspirantes (13) qui sont maintenues par la tête rotative (11), et une image de surface latérale d'au moins la section d'extrémité inférieure des deux buses aspirantes (13A, 13C) qui sont positionnées aux deux extrémités de la buse aspirante (13B) ; et
un dispositif de traitement d'image qui est configuré pour traiter l'image qui est capturée par le dispositif d'imagerie (41),
dans lequel le dispositif d'imagerie (41) dispose d'un capteur d'image (42) et d'une unité de système optique (43) qui est configurée pour constituer une image de surface latérale d'une partie cible d'imagerie de chacune des trois buses aspirantes (13A, 13B, 13C) sur une surface réceptrice de lumière du capteur d'image (42) de sorte que les images de surface latérale ne se chevauchent pas,
le procédé de montage de composants étant **caractérisé par**
entraînement du dispositif de traitement d'image à traiter des images des deux buses aspirantes (13A, 13C), qui sont positionnées aux deux extrémités de la rangée des trois buses aspirantes (13A, 13B, 13C), qui sont capturées en tant que cibles d'imagerie pendant l'opération d'aspiration et de montage de composant de sorte à confirmer si les buses aspirantes (13A, 13C) aspirent ou non un composants et le positionnement d'aspiration des composants, et pour traiter l'image de la buse d'aspiration (13B), qui est positionnée au milieu des trois buses aspirantes (13A, 13B, 13C) qui est capturée pendant une opération de remplacement de buse, en tant que la cible d'imagerie pour identifier la présence ou l'absence de la buse aspirante (13B).

2. Le procédé de montage de composants selon la revendication 1,
dans lequel l'unité de système optique (43) est configurée de sorte qu'une image de surface latérale d'une section supérieure de la buse aspirante (13B) qui est positionnée au milieu des trois buses aspirantes (13A, 13B, 13C) est constituée sur un côté de section supérieure de la surface réceptrice de lumière du capteur d'image (42), et les images de surface latérale d'une section supérieure des deux buses aspirantes (13A, 13C) qui sont positionnées aux deux extrémités de la rangée des trois buses aspirantes (13A, 13B, 13C) sont constituées sur une ligne de gauche à droite sur le côté d'extrémité inférieure sur la surface réceptrice de lumière du capteur d'image (42).

3. Le procédé de montage de composants selon la revendication 1,
dans lequel l'unité de système optique (43) est configurée de sorte que l'image de surface latérale de la partie cible d'imagerie des trois buses aspirantes (13A, 13B, 13C) est constituée de sorte à s'aligner sur la surface réceptrice de lumière du capteur d'image (42) dans la direction transverse.
